# EUROPÄISCHE PATENTSCHRIFT

(11) **EP 3 920 354 B1**
(45) Veröffentlichungstag und Bekanntmachung des Hinweises auf die Patenterteilung: **20.03.2024**
(21) Anmeldenummer: 21173322.5
(22) Anmeldetag: 11.05.2021
(51) Int. Cl.: H02H 3/33, B60L 3/04, G01R 31/28, H01H 83/04

(54) **ELEKTRISCHE SCHALTUNGSANORDNUNG, VERWENDUNG UND VERFAHREN ZUR EXTERNEN FUNKTIONSPRÜFUNG EINER FEHLERSTROM-SCHUTZEINRICHTUNG**
ELECTRICAL CIRCUIT ARRANGEMENT, USE AND METHOD FOR EXTERNAL FUNCTION TESTING OF A FAULT CURRENT PROTECTION DEVICE
AGENCEMENT DE CIRCUIT ÉLECTRIQUE, UTILISATION ET PROCÉDÉ DE VÉRIFICATION EXTERNE DE FONCTIONNEMENT D'UN DISPOSITIF DE PROTECTION CONTRE LES COURANTS DE FUITE

(30) Priorität: 04.06.2020 DE 102020114799
(43) Veröffentlichungstag der Anmeldung: 08.12.2021
(73) Patentinhaber: Bender GmbH & Co. KG, 35305 Grünberg (DE)
(72) Erfinder: FREITAG, Steffen, 35321 Laubach (DE); MORICH, Lars, 65604 Elz (DE)
(74) Vertreter: advotec.

(56) Entgegenhaltungen:
- EP-A2- 0 502 393
- DE-A1- 19 615 048
- US-B1- 6 421 214

## Beschreibung

Die Erfindung betrifft eine elektrische Schaltungsanordnung und deren Verwendung zur Funktionsprüfung einer in einem Stromversorgungssystem installierten ersten Fehlerstrom-Schutzeinrichtung mit einer Rückstellmotor-Einrichtung durch externe Beschaltung dieser Fehlerstrom-Schutzeinrichtung.

Weiterhin betrifft die Erfindung eine Ladestation für ein Elektrofahrzeug, wobei die Ladestation einen Laderegler mit einem Netzteil aufweist, das über einen vor der ersten Fehlerstrom-Schutzeinrichtung abgehenden Leitungszweig mit einem Leitungsschutzschalter an das Stromversorgungssystem angeschlossen ist.

Die Erfindung betrifft ferner ein Prüfverfahren zur Funktionsprüfung einer in einem Stromversorgungssystem installierten ersten Fehlerstrom-Schutzeinrichtung mit einer Rückstellmotor-Einrichtung durch externe Beschaltung der ersten Fehlerstrom-Schutzeinrichtung mittels der erfindungsgemäßen elektrischen Schaltungsanordnung.

Weiterhin betrifft die Erfindung eine Anwendung des erfindungsgemäßen Prüfverfahrens in einer Ladestation für ein Elektrofahrzeug, wobei die Ladestation einen Laderegler mit einem Netzteil aufweist, das über einen vor der ersten Fehlerstrom-Schutzeinrichtung abgehenden Leitungszweig mit einem Leitungsschutzschalter an das Stromversorgungssystem angeschlossen ist.

Aus dem Stand der Technik sind auf dem Gebiet des Personen- und Brandschutzes für elektrische Anlagen Fehlerstrom-Schutzeinrichtungen (RCD - Residual Current Device) bekannt. Sie basieren auf dem Differenzstrommessprinzip, nach dem alle aktiven Leiter - in einem 3-phasigen Stromversorgungssystem die Außen- bzw. Phasenleiter L1, L2, L3 sowie der Neutralleiter N, ausgenommen ist also der Schutzleiter PE - eines Stromversorgungssystems oder eines zu schützenden Leitungszweiges als Primärwicklung durch einen Messstromwandler der Fehlerstrom-Schutzeinrichtung geführt werden.

In einem fehlerfreien Stromversorgungssystem ist die vektorielle Summe der durch den Messstromwandler geführten Leiterströme gleich Null, sodass in einer Sekundärwicklung des Messstromwandlers keine Spannung induziert wird. Fließt hingegen ein Fehlerstrom an dem Messstromwandler "vorbei" über Erde ab, induziert der durch die Stromdifferenz verursachte (veränderliche) magnetische Fluss eine Spannung in der Sekundärwicklung des Messstromwandlers. Die induzierte Sekundärspannung bewirkt über elektromechanische Schaltkontakte in der Fehlerstrom-Schutzeinrichtung eine Abschaltung des zu überwachenden Anlagenteils.

Zur Funktionsprüfung weisen bekannte Fehlerstrom-Schutzeinrichtungen einen internen Prüfstromkreis auf. Durch Betätigen einer Prüftaste wird ein erzwungener Prüfstrom an dem Messstromwandler vorbeigeführt und so eine Stromdifferenz hervorgerufen, die zur Auslösung der Fehlerstrom-Schutzeinrichtung führt.

Für spezielle Anwendungen sind geltende Normen und Anschlussbedingungen zu erfüllen. Insbesondere gilt dies beispielsweise für in Ladestation für Elektrofahrzeuge nach der Norm IEC 61851-1 verbaute Fehlerstrom-Schutzeinrichtungen.

Von besonderer Bedeutung ist hierbei die Sicherstellung und Erkennung der ordnungsgemäßen Funktion der Fehlerstrom-Schutzeinrichtung durch externe übergeordnete Steuereinheiten oder Prüfvorrichtungen. Üblicherweise erfolgt die Erkennung außerhalb der Fehlerstrom-Schutzeinrichtung oder die Rückmeldung einer Auslösung der Fehlerstrom-Schutzeinrichtung mittels Hilfskontakten, die in der Ladestation integriert sind. Diese Hilfskontaktierung aber benötigt in nachteiliger Weise Bauraum und erhöht die Installations- und Betriebskosten.

Auch kann das Aufschalten eines externen Prüfstroms bei einer ausgelöster Fehlerstrom-Schutzeinrichtung zu Gefahrensituationen führen.

Soll beispielsweise mittels einer externen Prüfvorrichtung eine Funktionsprüfung der Fehlerstrom-Schutzeinrichtung vorgenommen werden, nachdem aufgrund eines Fehlers in der elektrischen Anlage die Stromversorgungsleitung durch die Fehlerstrom-Schutzeinrichtung aufgetrennt worden ist, so wird ein externer Prüfstrom auf die spannungsfreie Leitung gegeben, der eine Personengefährdung darstellen kann.

Weiter sind aus dem Stand der Technik Fehlerstrom-Schutzeinrichtungen mit Funktionsüberwachungen bekannt.

So zeigt die Offenlegungsschrift DE 196 15 048 A1 einen halbautomatischen Fehlerstromschutzschalter, bei dem eine erzwungene Prüfung mit Trennung der Stromversorgung bei Anschließen oder Einschalten eines Verbrauchers durchgeführt wird. Nach erfolgter Prüfung muss die Trennung manuell aufgehoben werden.

In der EP 0 502 393 A2 ist ein Fehlerstromschutzschalter offenbart, der in bestimmten Zeitabständen eine automatische Prüfung wiederholt. Eine Fehlfunktion wird mittels einer Überwachungseinrichtung festgestellt, welche die Auslösung eines Hilfsschalters prüft.

Die Patentschrift US 6,421,214 B1 beschreibt einen Schutzschalter zur Lichtbogen- und Erdschlusserkennung, bei dem ein Mikroprozessor die Funktionsfähigkeit der Komponenten mit einem Selbsttest überwacht.

Im Folgenden wird davon ausgegangen, dass - insbesondere im Hinblick auf die hier betrachtete externe Funktionsprüfung - die Fehlerstrom-Schutzeinrichtung mit einer - nicht zur Erfindung gehörenden - Rückstellmotor-Einrichtung versehen ist, bei deren Spannungsbeaufschlagung eine Rückstellung der Fehlerstrom-Schutzeinrichtung erfolgt.

Der vorliegenden Erfindung liegt somit die Aufgabe zu Grunde, eine Vorrichtung und ein Verfahren vorzuschlagen, mit denen durch eine externe Beschaltung einer Fehlerstrom-Schutzeinrichtung eine zuverlässige und gefahrlose Funktionsprüfung der Fehlerstrom-Schutzeinrichtung ermöglicht wird. Neben der Verwendung zur Funktionsprüfung in einem allgemeinen Stromversorgungssystem ist dabei die Verwendung in einer Ladestation für ein Elektrofahrzeug in Betracht zu ziehen.

Diese Aufgabe wird gelöst durch eine elektrische Schaltungsanordnung zur Funktionsprüfung einer in einem Stromversorgungssystem installierten ersten Fehlerstrom-Schutzeinrichtung mit den Merkmalen nach Anspruch 1.

Die elektrische Schaltungsanordnung weist erfindungsgemäß eine Rückstell-Anschlussklemme, eine Prüf-Anschlussklemme und eine Spannungs-Anschlussklemme auf.

Zwischen der Rückstell-Anschlussklemme und der Prüf-Anschlussklemme ist ein über ein Rückstellkontakt-Steuersignal steuerbarer Rückstell-Schaltkontakt angeordnet.

Zwischen der Prüf-Anschlussklemme und der Spannungs-Anschlussklemme ist eine Reihenschaltung mit einem über ein Prüfkontakt-Steuersignal steuerbaren Prüf-Schaltkontakt und einem Prüfstrom-Begrenzer angeordnet.

Unabhängig voneinander kann somit die Prüf-Anschlussklemme über den geschlossenen Prüf-Schaltkontakt und den Prüfstrom-Begrenzer mit der Spannungs-Anschlussklemme elektrisch leitend verbunden werden, ebenso wie die Prüf-Anschlussklemme über den geschlossenen Rückstell-Schaltkontakt mit der Rückstell-Anschlussklemme elektrisch leitend verbunden werden kann.

Bei geschlossenem Prüf-Schaltkontakt begrenzt der Prüfstrom-Begrenzer den Stromfluss in der aus Prüf-Schaltkontakt und Prüfstrom-Begrenzer gebildeten Reihenschaltung zwischen der Prüf-Anschlussklemme und der Spannungs-Anschlussklemme.

Sowohl der Rückstell-Schaltkontakt als auch der Prüf-Schaltkontakt können jeweils über ein Steuersignal (Rückstellkontakt-Steuersignal bzw. Prüfkontakt-Steuersignal) in den offenen bzw. geschlossenen Zustand versetzt werden. Die Schaltkontakte können elektromechanisch als Relais oder elektronisch als Halbleiter-Bauelement ausgeführt sein.

Zur Erkennung einer zwischen der Prüf-Anschlussklemme und der Spannungs-Anschlussklemme anliegenden elektrischen Spannung (Netzspannung des Stromversorgungssystems) sind erfindungsgemäß die Prüf-Anschlussklemme mit einem ersten Spannungs-Messeingang und die Spannungs-Anschlussklemme mit einem zweiten Spannungs-Messeingang einer Spannungs-Messeinrichtung verbunden.

Liegt zwischen der Prüf-Anschlussklemme und der Spannungs-Anschlussklemme die Netzspannung an, so wird diese Information von der Spannungs-Messeinrichtung erkannt und an einem Spannungs-Messsignalausgang bereitgestellt.

Eine Verriegelungseinrichtung ist mit dem Spannungs-Messsignalausgang verbunden, um das der Verriegelungseinrichtung von außen - beispielsweise von einer übergeordneten Steuereinheit wie eine Ladeeinrichtung einer Ladestation - zum Schließen des Prüf-Schaltkontaktes zugeführte Prüfkontakt-Steuersignal elektrisch zu verriegeln, also das Prüfkontakt-Steuersignal zum Aktivieren des Prüfstroms nicht wirksam werden zu lassen.

Erfindungsgemäß wird somit das Prüfkontakt-Steuersignal zum Schließen des Prüf-Schaltkontaktes nur dann an den Prüf-Schaltkontakt weitergeleitet, wenn über den Spannungs-Messsignalausgang von der Spannungs-Messeinrichtung eine Netzspannung signalisiert wird. Wird keine Netzspannung erkannt, so wird das Prüfkontakt-Steuersignal von der Verriegelungseinrichtung nicht durchgeleitet ("verriegelt") und der Prüf-Schaltkontakt verharrt in geöffnetem Zustand oder geht in diesen über. In vorteilhafter Weise wird die erfindungsgemäße elektrische Schaltungsanordnung zur Prüfung der in einem Stromversorgungssystem installierten ersten Fehlerstrom-Schutzeinrichtung verwendet.

Die elektrische Schaltungsanordnung stellt eine externe Beschaltung der installierten ersten Fehlerstrom-Schutzeinrichtung dar, mit der die Funktion dieser Fehlerstrom-Schutzeinrichtung geprüft werden kann.

Dabei ist die Rückstell-Anschlussklemme mit der - als Bestandteil der ersten Fehlerstrom-Schutzeinrichtung vorausgesetzten, nicht zur Erfindung gehörenden - Rückstellmotor-Einrichtung der ersten Fehlerstrom-Schutzeinrichtung verbunden, die Prüf-Anschlussklemme ist mit einem ersten aktiven Leiter - in einem dreiphasigen Stromversorgungssystem vorzugsweise einer der drei Phasenleiter L1, L2, L3 - des Stromversorgungsystems vor der ersten Fehlerstrom-Schutzeinrichtung verbunden und die Spannungs-Anschlussklemme ist mit einem zweiten aktiven Leiter - vorzugsweise der Neutralleiter N - des Stromversorgungsystems nach der ersten Fehlerstrom-Schutzeinrichtung verbunden.

Die richtungsbezogenen Angaben "vor/nach" beziehen sich hier auf die Richtung des elektrischen Energieflusses von einer Stromeinspeisung (beispielsweise ein Transformator) zum Verbraucher (beispielsweise ein Elektrofahrzeug).

Durch Schließen des Prüf-Schaltkontaktes fließt somit bei vorhandener Netzspannung ein definierter Prüfstrom über die Prüf-Anschlussklemme und die Spannungs-Anschlussklemme an dem Messstromwandler der ersten Fehlerstrom-Schutzeinrichtung vorbei und führt bei deren ordnungsgemäßer Funktion zur Auslösung, in der Regel zu einer allpoligen Trennung der Stromversorgungsleitung.

Die hier in der vorliegenden Anwendungsumgebung betrachtete erste Fehlerstrom-Schutzeinrichtung umfasst die (nicht zur Erfindung gehörende) Rückstellmotor-Einrichtung, mit der die Fehlerstrom-Schutzeinrichtung zurückgestellt werden kann, also die zu überwachenden Versorgungsleitung wieder zugeschaltet wird.

Der der Erfindung zu Grunde liegende Lösungsgedanke spiegelt sich auch in einem erfindungsgemäßen Prüfverfahren nach Anspruch 6 zur Funktionsprüfung der in einem Stromversorgungssystem installierten ersten Fehlerstrom-Schutzeinrichtung wider.

Das Prüfverfahren umfasst dabei die in der erfindungsgemäßen elektrischen Schaltungsanordnung nach Anspruch 1 umgesetzten, im Folgenden erläuterten Verfahrensschritte.

Mittels der Spannungs-Messeinrichtung erfolgt zunächst eine Prüfung, ob die Netzspannung zwischen dem ersten - vorzugsweise einem Phasenleiter - und dem zweiten - vorzugsweise der Neutralleiter - aktiven Leiter des Stromversorgungssystems vorhanden ist. Dabei werden der erste aktive Leiter vor der ersten Fehlerstrom-Schutzeinrichtung über die Prüf-Anschlussklemme mit dem ersten Spannungs-Messeingang und der zweite aktive Leiter nach der ersten Fehlerstrom-Schutzeinrichtung über die Spannungs-Anschlussklemme mit dem zweiten Spannungs-Messeingang verbunden.

Falls die Netzspannung von der Spannungs-Messeinrichtung erkannt wird, erfolgt bei anliegendem Prüfkontakt-Steuersignal ein Schließen des Prüf-Schaltkontaktes, sodass in einem Prüfstromkreis über die Prüf-Anschlussklemme und die Spannungs-Anschlussklemme für eine bestimmte Zeitdauer von dem ersten aktiven Leiter zu dem zweiten aktiven Leiter ein definierter Prüfstrom an dem Messstromwandler vorbei fließt und ein Auslösen der ersten Fehlerstrom-Schutzeinrichtung bei deren ordnungsgemäßer Funktion bewirkt.

Daraufhin wird nach der ersten Fehlerstrom-Schutzeinrichtung keine Netzspannung mehr erkannt und es erfolgt aufgrund der Verriegelung des Prüfkontakt-Steuersignals ein Öffnen des Prüf-Schaltkontaktes, sodass der Prüfstromkreis unterbrochen wird.

Wegen der Verriegelung ist ein erneutes Schließen des Prüfstrom-Schaltkontaktes erst wieder bei erkannter Netzspannung möglich.

Das Wiedereinschalten der ersten Fehlerstrom-Schutzeinrichtung erfolgt mittels des Rückstellkontakt-Steuersignals, wobei über den Rückstell-Schaltkontakt die Rückstellmotor-Einrichtung der ersten Fehlerstrom-Schutzeinrichtung mit der Netzspannung beaufschlagt wird.

Infolge des Wiedereinschaltens erkennt die Spannungs-Messeinrichtung eine nach der ersten Fehlerstrom-Schutzeinrichtung anliegende Netzspannung und die elektrische Verriegelung des Prüf-Schaltkontaktes wird aufgehoben.

Falls nach dem kurzzeitigen Fließen des definierten Prüfstroms weiterhin eine Netzspannung durch die Spannungs-Messeinrichtung detektiert wird, liegt eine Fehlfunktion der ersten Fehlerstrom-Schutzeinrichtung vor, d.h. die zu überwachende Stromversorgungsleitung wurde nicht funktionsgemäß getrennt.

Vorzugsweise wird die erfindungsgemäße elektrische Schaltungsanordnung zur Funktionsprüfung der ersten Fehlerstrom-Schutzeinrichtung in einer Ladestation für Elektrofahrzeuge verwendet.

Dabei weist die nicht zur Erfindung gehörende Ladestation einen Laderegler mit einem Netzteil auf, wobei das Netzteil über einen vor der ersten Fehlerstrom-Schutzeinrichtung abgehenden Leitungszweig mit einem - ebenfalls nicht zur Erfindung gehörenden - Leitungsschutzschalter mit dem Stromversorgungssystem verbunden ist.

Übergeordnete Funktionen wie die das Erzeugen und Anlegen des Prüfkontakt-Steuersignals und des Rückstellkontakt-Steuersignals werden in dieser Anwendungsumgebung von einem zu der Ladestation gehörenden Laderegler übernommen.

Zur Detektion der Netzspannung sowie zur Ausbildung eines Prüfstromkreises ist die Prüf-Anschlussklemme mit einem ersten aktiven Leiter des Stromversorgungssystems zwischen dem Leitungsschutzschalter und dem Netzteil verbunden und die Spannungs-Anschlussklemme ist mit einem zweiten aktiven Leiter des Stromversorgungssystems nach der Fehlerstrom-Schutzeinrichtung verbunden.

Zum Wiedereinschalten der ersten Fehlerstrom-Schutzeinrichtung ist die Rückstell-Anschlussklemme mit der Rückstellmotor-Einrichtung der ersten Fehlerstrom-Schutzeinrichtung verbunden.

Falls in der Ladestation der Laderegler mit Netzteil über eine dem Leitungsschutzschalter nachgeschaltete zweite Fehlerstrom-Schutzeinrichtung geschützt ist, ist zum Verbinden der Spannungs-Anschlussklemme eine Anschlussleitung über die zweite Fehlerstrom-Schutzeinrichtung geführt und mit dem zweiten aktiven Leiter des Stromversorgungssystems nach der ersten Fehlerstrom-Schutzeinrichtung verbunden.

Da nur die Prüfung der ersten Fehlerstrom-Schutzeinrichtung beabsichtigt ist, darf der für die erste Fehlerstrom-Schutzeinrichtung zugedachte Prüfstrom nicht auch an der zweiten Fehlerstrom-Schutzeinrichtung vorbei geführt werden.

In einer weiteren Verwendung kann ein Schütz - als Haupt-Abschaltglied zur Trennung des anzuschließenden Elektrofahrzeugs - auf seine Funktion geprüft werden.

Sofern dieses Schütz für eine Prüfung geschlossen werden darf und sichergestellt ist, dass kein Elektrofahrzeug an die Ladestation angeschlossen ist (kein Ladestecker eingesteckt), kann die Spannungs-Anschlussklemme - gegebenenfalls mit einer Anschlussleitung über die zweite Fehlerstrom-Schutzeinrichtung geführt - mit dem zweiten aktiven Leiter nach diesem Schütz verbunden werden. Das Schütz kann somit auf seine Funktionsfähigkeit insbesondere auf verschweißte Kontakte geprüft werden. Während der Prüfung der ersten Fehlerstrom-Schutzeinrichtung muss das Schütz folglich geschlossen sein.

Weitere vorteilhafte Ausgestaltungsmerkmale ergeben sich aus der nachfolgenden Beschreibung und den Zeichnungen, die ein bevorzugte Ausführungsformen der Erfindung und deren Anwendung anhand von Beispielen erläutern.

Es zeigen:
- **Figur 1**: eine erfindungsgemäße elektrische Schaltungsanordnung zur Funktionsprüfung einer FehlerstromSchutzeinrichtung,
- **Figur 2**: die Verwendung der erfindungsgemäßen elektrischen Schaltungsanordnung nach Figur 1 in einem Stromversorgungssystem,
- **Figur 3**: die Verwendung der erfindungsgemäßen elektrischen Schaltungsanordnung nach Figur 1 in einer Ladestation für Elektrofahrzeuge und
- **Figur 4**: eine weitere Verwendung der erfindungsgemäßen elektrischen Schaltungsanordnung in einer Ladestation für Elektrofahrzeuge.

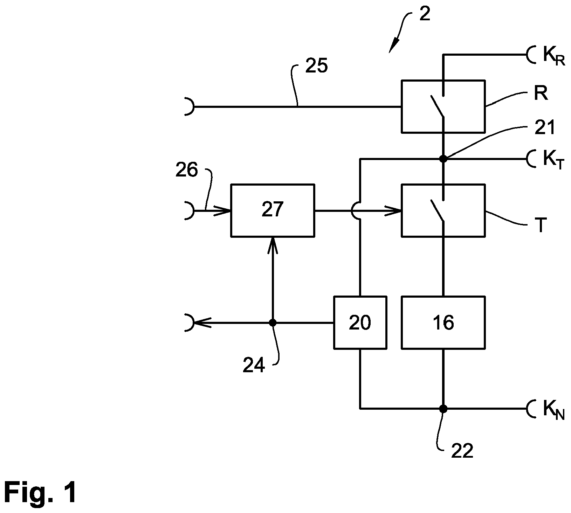

**Figur 1** zeigt ein funktionales Blockdiagramm der erfindungsgemäßen elektrischen Schaltungsanordnung 2.

Die Schaltungsanordnung 2 weist eine Rückstell-Anschlussklemme K_{R}, eine Prüf-Anschlussklemme K_{T} und eine Spannungs-Anschlussklemme K_{N} auf.

Zwischen der Rückstell-Anschlussklemme K_{R} und der Prüf-Anschlussklemme K_{T} liegt ein über ein Rückstellkontakt-Steuersignal 25 steuerbarer Rückstell-Schaltkontakt R.

Zwischen der Prüf-Anschlussklemme K_{T} und der Spannungsanschlussklemme K_{N} liegt eine Reihenschaltung bestehend aus einem über ein Prüfkontakt-Steuersignal 26 steuerbaren Prüf-Schaltkontakt T und einem den Prüfstrom begrenzenden Prüfstrom-Begrenzer 16.

Mit der Prüf-Anschlussklemme K_{T} ist ein erster Spannungs-Messeingang 21 und mit der Spannungs-Anschlussklemme K_{N} ist ein zweiter Spannungs-Messeingang 22 einer Spannungs-Messeinrichtung 20 verbunden.

Eine zwischen der Prüf-Anschlussklemme K_{T} und der Spannungs-Anschlussklemme K_{N} anliegende (Netz-)Spannung wird von der Spannungs-Messeinrichtung 20 erkannt und über einen Spannungs-Messsignalausgang 24 an eine Verriegelungseinrichtung 27 weitergeleitet.

Die Spannungs-Messeinrichtung 20 kann als Optokoppler ausgeführt sein, um an einem Optokopplerausgang (Spannungs-Messsignalausgang 24) eine Potentialtrennung von der an dem Optokopplereingang (erster 21 und zweiter 22 Spannungs-Messeingang) erfassten Spannung zu gewährleisten.

Die Verriegelungseinrichtung 27 verriegelt bei Anliegen einer zwischen der Prüf-Anschlussklemme K_{T} und der Spannungs-Anschlussklemme K_{N} anliegenden (Netz-)Spannung das Prüfkontakt-Steuersignal 26, sodass der Prüf-Schaltkontakt T nicht geschlossen werden kann und damit kein Personen-gefährdender Prüfstrom fließen kann.

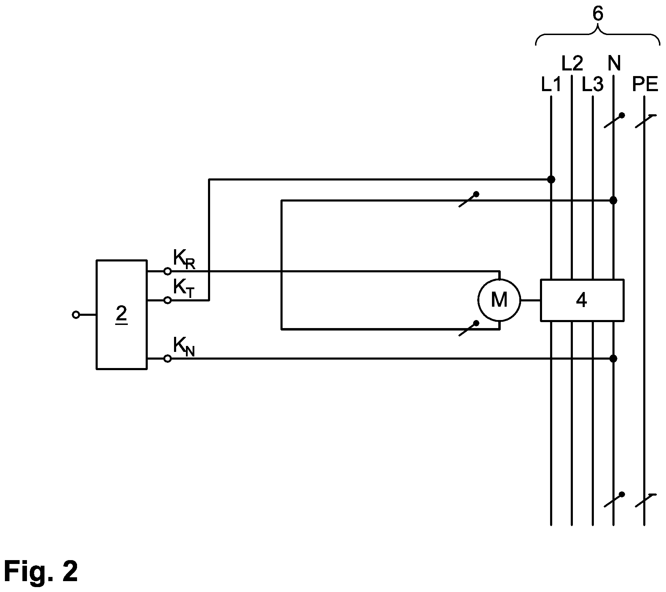

**Figur 2** zeigt die Verwendung der erfindungsgemäßen Schaltungsanordnung 2 aus Figur 1 zur Funktionsprüfung einer in einem Stromversorgungssystem 6 installierten ersten Fehlerstrom-Schutzeinrichtung 4.

Das Stromversorgungssystem 6 ist hier als dreiphasiges Stromversorgungssystem 6 mit aktiven Leitern L1, L2, L3, N und dem Schutzleiter PE ausgeführt.

Die Prüf-Anschlussklemme K_{T} der Schaltungsanordnung 2 ist mit dem aktiven Leiter L1 (Außen-/Phasenleiter) des Stromversorgungssystems 6 vor der ersten Fehlerstrom-Schutzeinrichtung 4 verbunden, die Spannungs-Anschlussklemme K_{N} der Schaltungsanordnung 2 ist nach der ersten Fehlerstrom-Schutzeinrichtung 4 mit dem aktiven Leiter N (Neutralleiter) des Stromversorgungssystems 6 verbunden, sodass sich bei geschlossenem Prüf-Schaltkontakt T ein in seiner Stromstärke begrenzter Prüfstrom ausbildet, der an dem Messstromwandler der ersten Fehlerstrom-Schutzeinrichtung 4 vorbeigeführt wird und zum Auslösen der ersten Fehlerstrom-Schutzeinrichtung 4 führt.

Infolge des Auslösens der ersten Fehlerstrom-Schutzeinrichtung 4 wird über die Prüf-Anschlussklemme K_{T} und die Spannungs-Anschlussklemme K_{N} mittels des ersten 21 und des zweiten 22 Spannungs-Messeingangs keine Spannung mehr detektiert, sodass in der Verriegelungseinrichtung 27 das Prüfkontakt-Steuersignals 26 zum Schließen des Prüf-Schaltkontaktes T verriegelt, also nicht wirksam wird, der Prüf-Schaltkontakt T geöffnet und der Prüfstrom unterbrochen wird.

In vorteilhafter Weise ist daher bei freigeschalteten, also spannungsfreien Stromversorgungsleitungen das erneute Einschalten eines Personen gefährdenden Prüfstroms nicht mehr möglich.

Zum Wiedereinschalten der ersten Fehlerstrom-Schutzeinrichtung 4 wird der erste aktive Leiter L1 von einem Abgriff vor der ersten Fehlerstrom-Schutzeinrichtung 4 über die Prüf-Anschlussklemme K_{T}, über den geschlossenen Rückstell-Schaltkontakt R und die Rückstell-Anschlussklemme K_{R} auf einen ersten Anschluss der Rückstellmotor-Einrichtung M der ersten Fehlerstrom-Schutzeinrichtung 4 gelegt. Der zweite aktive Leiter N ist direkt über einen Abgriff vor der ersten Fehlerstrom-Schutzeinrichtung 4 mit einem zweiten Anschluss der Rückstellmotor-Einrichtung M verbunden, sodass die Rückstellmotor-Einrichtung M zur Rückstellung der ersten Fehlerstrom-Schutzeinrichtung 4 mit der Netzspannung beaufschlagt wird.

Über die Prüf-Anschlussklemme K_{T} und die Spannungs-Anschlussklemme K_{N} und dem jeweils damit verbundenen ersten 21 und des zweiten 22 Spannungs-Messeingang der Spannungs-Messeinrichtung 20 wird das Wiedereinschalten der ersten Fehlerstrom-Schutzeinrichtung 4 festgestellt und mittels der Verriegelungseinrichtung 27 die Verriegelung des Prüfkontakt-Steuersignals 26 aufgehoben, sodass eine erneute Prüfung mit einem Prüfstrom stattfinden kann.

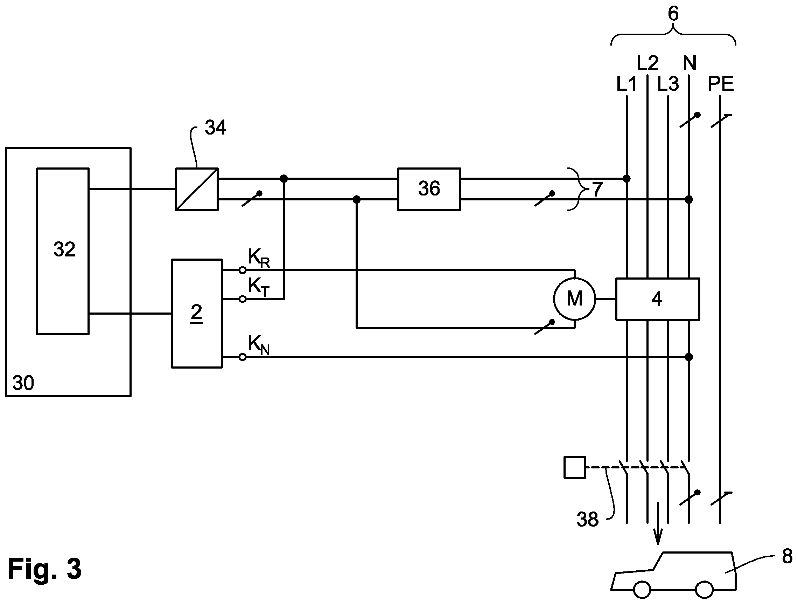

**Figur 3** zeigt die Verwendung der erfindungsgemäßen Schaltungsanordnung 2 aus Figur 1 in einer Ladestation 30 für ein Elektrofahrzeug 8.

Die Ladestation 30 weist einen Laderegler 32 mit einem Netzteil 34 auf, das über einen vor der ersten Fehlerstrom-Schutzeinrichtung 4 von dem Stromversorgungssystem 6 abgehenden Leitungszweig 7 und einen Leitungsschutzschalter 36 mit dem Stromversorgungssystem 6 verbunden ist.

Als (Haupt-)Trennvorrichtung zu dem Elektrofahrzeug 8 ist nach der ersten Fehlerstrom-Schutzeinrichtung 4 ein (Schalt-)Schütz 38 vorgesehen.

In Ergänzung der allgemeinen Verwendung für eine erste Fehlerstrom-Schutzeinrichtung 4 nach Figur 2 ist die Prüf-Anschlussklemme K_{T} mit einem ersten aktiven Leiter L1 in dem abgehenden Leitungszweig 7 des Stromversorgungsystems 6 zwischen dem Leitungsschutzschalter 36 und dem Netzteil 34 verbunden.

Der Abgriff des zweiten aktiven Leiters N zur Rückstellung der Rückstellmotor-Einrichtung M befindet sich ebenfalls zwischen dem Leitungsschutzschalter 36 und dem Netzteil 34.

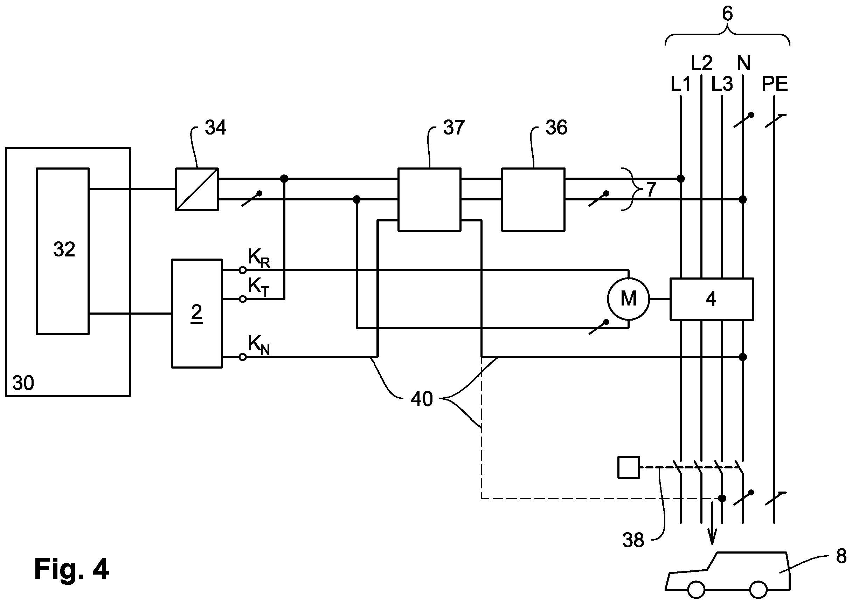

**Figur 4** zeigt eine weitere Verwendung der erfindungsgemäßen Schaltungsanordnung 2, falls der Laderegler 32 mit dem Netzteil 34 selbst über eine zweite Fehlerstrom-Schutzeinrichtung 37 geschützt ist.

In diesem Fall ist eine Anschlussleitung 40 zwischen der Spannungs-Anschlussklemme K_{N} und dem zweiten aktiven Leiter N über diese zweite Fehlerstrom-Schutzeinrichtung 37 zu führen. Dies ist erforderlich, da zur Prüfung der ersten Fehlerstrom-Schutzeinrichtung 4 der Prüfstrom nur an dieser ersten Fehlerstrom-Schutzeinrichtung 4 - nicht auch an der zweiten Fehlerstrom-Schutzeinrichtung 37, da diese sonst ebenfalls auslösen würde - vorbei geführt werden muss.

Sofern ein zur Trennung des Elektrofahrzeugs 8 installiertes Schütz 38 auf eine einwandfreie Funktion, d.h. eine ordnungsgemäße Trennung, geprüft werden soll, kann die Anschlussleitung 40 alternativ nach dem Schütz 38 an den zweiten aktiven Leiter N angeschlossen werden.

## Patentansprüche

1. Elektrische Schaltungsanordnung (2) zur Funktionsprüfung einer in einem Stromversorgungssystem (6) installierten ersten Fehlerstrom-Schutzeinrichtung (4) mit einer Rückstellmotor-Einrichtung (M) durch externe Beschaltung der ersten Fehlerstrom-Schutzeinrichtung (4),
**gekennzeichnet durch**
eine Rückstell-Anschlussklemme (K_{R}) , eine Prüf-Anschlussklemme (K_{T}) und eine Spannungs-Anschlussklemme (K_{N}),
einen zwischen der Rückstell-Anschlussklemme (K_{R}) und der Prüf-Anschlussklemme (K_{T}) angeordneten, über ein Rückstellkontakt-Steuersignal (25) steuerbaren Rückstell-Schaltkontakt (R),
eine zwischen der Prüf-Anschlussklemme (K_{T}) und der Spannungsanschlussklemme (K_{N}) angeordnete Reihenschaltung mit einem über ein Prüfkontakt-Steuersignal (26) steuerbaren Prüf-Schaltkontakt (T) und einem Prüfstrom-Begrenzer (16),
eine Spannungs-Messeinrichtung (20) zur Erkennung einer Netzspannung des Stromversorgungssystems (6), mit einem mit der Prüf-Anschlussklemme (K_{T}) verbundenen ersten Spannungs-Messeingang (21), mit einem mit der Spannungs-Anschlussklemme (K_{N}) verbundenen zweiten Spannungs-Messeingang (22) und mit einem Spannungs-Messsignalausgang (24),
eine Verriegelungseinrichtung (27), die mit dem Spannungs-Messsignalausgang (24) verbunden ist, zur elektrischen Verriegelung des Prüfkontakt-Steuersignals (26).

2. Prüfanordnung mit der elektrischen Schaltungsanordnung (2) nach Anspruch 1 ,
**dadurch gekennzeichnet, dass**
die Rückstell-Anschlussklemme (K_{R}) mit der Rückstellmotor-Einrichtung (M) der ersten Fehlerstrom-Schutzeinrichtung (4) verbunden ist, die Prüf-Anschlussklemme (K_{T}) mit einem ersten aktiven Leiter (L1) des Stromversorgungsystems (6) vor der ersten Fehlerstrom-Schutzeinrichtung (4) verbunden ist und
die Spannungs-Anschlussklemme (K_{N}) mit einem zweiten aktiven Leiter (N) des Stromversorgungsystems (6) nach der ersten Fehlerstrom-Schutzeinrichtung (4) verbunden ist.

3. Ladestation (30) für ein Elektrofahrzeug (8) mit der elektrischen Schaltungsanordnung (2) nach Anspruch 1, wobei die Ladestation (30) einen Laderegler (32) mit einem Netzteil (34) aufweist, das über einen vor der ersten Fehlerstrom-Schutzeinrichtung (4) abgehenden Leitungszweig (7) mit einem Leitungsschutzschalter (36) an das Stromversorgungssystem (6) angeschlossen ist,
**dadurch gekennzeichnet, dass**
die Rückstell-Anschlussklemme (K_{R}) mit der Rückstellmotor-Einrichtung (M) der ersten Fehlerstrom-Schutzeinrichtung (4) verbunden ist, die Prüf-Anschlussklemme (K_{T}) mit einem ersten aktiven Leiter (L1) in dem abgehenden Leitungszweig (7) des Stromversorgungsystems (6) zwischen dem Leitungsschutzschalter (36) und dem Netzteil (34) verbunden ist und
die Spannungs-Anschlussklemme (K_{N}) mit einem zweiten aktiven Leiter (N) des Stromversorgungsystems (6) nach der ersten Fehlerstrom-Schutzeinrichtung (4) verbunden ist.

4. Ladestation (30) für ein Elektrofahrzeug (8) mit der elektrischen Schaltungsanordnung (2) nach Anspruch 1, wobei die Ladestation (30) zur Steuerung der elektrischen Schaltungsanordnung (2) einen Laderegler (32) mit einem Netzteil (34) aufweist, das über einen vor der ersten Fehlerstrom-Schutzeinrichtung (4) abgehenden Leitungszweig (7) mit einem Leitungsschutzschalter (36) und mit einer dem Leitungsschutzschalter (36) nachgeschalteten zweiten Fehlerstrom-Schutzeinrichtung (37) mit dem Stromversorgungssystem (6) verbunden ist,
**dadurch gekennzeichnet, dass**
die Rückstell-Anschlussklemme (K_{R}) mit der Rückstellmotor-Einrichtung (M) der ersten Fehlerstrom-Schutzeinrichtung (4) verbunden ist, die Prüf-Anschlussklemme (K_{T}) mit einem ersten aktiven Leiter (L1) in dem abgehenden Leitungszweig (7) des Stromversorgungsystems (6) zwischen der zweiten Fehlerstrom-Schutzeinrichtung (37) und dem Netzteil (34) verbunden ist und
eine Anschlussleitung (40) der Spannungs-Anschlussklemme (K_{N}) über die zweite Fehlerstrom-Schutzeinrichtung (37) geführt ist und mit einem zweiten aktiven Leiter (N) des Stromversorgungsystems (6) nach der ersten Fehlerstrom-Schutzeinrichtung (4) verbunden ist.

5. Ladestation nach Anspruch 3 oder 4,
**dadurch gekennzeichnet,**
**dass** die Anschlussleitung (40) der Spannungs-Anschlussklemme (K_{N}) mit dem zweiten aktiven Leiter (N) des Stromversorgungsystems (6) nach einem der ersten Fehlerstrom-Schutzeinrichtung(4) nachgeschalteten Schütz (38) verbunden ist.

6. Prüfverfahren zur Funktionsprüfung einer in einem Stromversorgungssystem (6) installierten ersten Fehlerstrom-Schutzeinrichtung (4) mit einer Rückstellmotor-Einrichtung (M) durch externe Beschaltung der ersten Fehlerstrom-Schutzeinrichtung (4) mittels einer elektrischen Schaltungsanordnung (2) nach Anspruch 1, umfassend die Verfahrensschritte:
Prüfen, ob eine Netzspannung zwischen einem ersten (L1) und einem zweiten (N) aktiven Leiter des Stromversorgungssystems (6) vorhanden ist mittels der Spannungs-Messeinrichtung (20), wobei der erste aktive Leiter (L1) vor der ersten Fehlerstrom-Schutzeinrichtung (4) über die Prüf-Anschlussklemme (K_{T}) mit dem ersten Spannungs-Messeingang (21) verbunden wird und der zweite aktive Leiter (N) nach der ersten Fehlerstrom-Schutzeinrichtung (4) über die Spannungs-Anschlussklemme (K_{N}) mit dem zweiten Spannungs-Messeingang (22) verbunden wird;
falls eine Netzspannung von der Spannungs-Messeinrichtung (20) erkannt wird, erfolgt bei anliegendem Prüfkontakt-Steuersignal (26) ein Schließen des Prüf-Schaltkontaktes (T), sodass in einem Prüfstromkreis über die Prüf-Anschlussklemme (K_{T}) und die Spannungs-Anschlussklemme (K_{N}) für eine bestimmte Zeitdauer ein definierter Prüfstrom von dem ersten aktiven Leiter (L1) zu dem zweiten aktiven Leiter (N) fließt und ein Auslösen der ersten Fehlerstrom-Schutzeinrichtung (4) bei deren ordnungsgemäßer Funktion erfolgt, oder,
falls keine Netzspannung von der Spannungs-Messeinrichtung (20) erkannt wird, erfolgt ein Verriegeln des Prüfkontakt-Steuersignals (26) durch die Verriegelungseinrichtung (27), und, falls der Prüf-Schaltkontakt (T) geschlossen ist, Öffnen des Prüf-Schaltkontaktes (T),
Wiedereinschalten der ersten Fehlerstrom-Schutzeinrichtung (4) mittels des Rückstellkontakt-Steuersignals (25), sodass über den geschlossenen Rückstell-Schaltkontakt (R) und über die Rückstell-Anschlussklemme (K_{R}) die Rückstellmotor-Einrichtung (M) der ersten Fehlerstrom-Schutzeinrichtung (4) mit der Netzspannung beaufschlagt wird und die wieder zugeschaltete Netzspannung nach der ersten Fehlerstrom-Schutzeinrichtung (4) durch die Spannungs-Messeinrichtung (20) erkannt wird und die elektrische Verriegelung des Prüf-Schaltkontaktes (T) durch die Verriegelungseinrichtung (27) aufgehoben wird;
falls nach dem Fließen des definierten Prüfstroms weiterhin eine Netzspannung durch die Spannungs-Messeinrichtung (20) detektiert wird, liegt eine Fehlfunktion der ersten Fehlerstrom-Schutzeinrichtung (4) vor.

7. Prüfverfahren nach Anspruch 6 in einer Ladestation (30) für ein Elektrofahrzeug (8), wobei die Ladestation (30) einen Laderegler (32) mit einem Netzteil (34) aufweist, das über einen vor der ersten Fehlerstrom-Schutzeinrichtung (4) abgehenden Leitungszweig (7) mit einem Leitungsschutzschalter (36) an das Stromversorgungssystem (6) angeschlossen ist,
**dadurch gekennzeichnet, dass**
die Prüf-Anschlussklemme (K_{T}) mit dem ersten aktiven Leiter (L1) in dem abgehenden Leitungszweig (7) des Stromversorgungsystems (6) zwischen dem Leitungsschutzschalter (36) und dem Netzteil (34) verbunden wird.

8. Prüfverfahren nach Anspruch 6 in einer Ladestation (30) für ein Elektrofahrzeug (8), wobei die Ladestation (30) zur Steuerung der elektrischen Schaltungsanordnung (2) einen Laderegler (32) mit einem Netzteil (34) aufweist, das über einen vor der ersten Fehlerstrom-Schutzeinrichtung (4) abgehenden Leitungszweig (7) mit einem Leitungsschutzschalter (36) und mit einer dem Leitungsschutzschalter (36) nachgeschalteten zweiten Fehlerstrom-Schutzeinrichtung (37) mit dem Stromversorgungssystem (6) verbunden ist,
**dadurch gekennzeichnet, dass**
eine Anschlussleitung (40) der Spannungs-Anschlussklemme (K_{N}) über die zweite Fehlerstrom-Schutzeinrichtung (37) geführt wird und mit dem zweiten aktiven Leiter (N) des Stromversorgungsystems (6) nach der ersten Fehlerstrom-Schutzeinrichtung (4) verbunden wird.

9. Prüfverfahren nach Anspruch 7 oder 8,
**dadurch gekennzeichnet, dass**
die Anschlussleitung (40) der Spannungs-Anschlussklemme (K_{N}) mit dem zweiten aktiven Leiter (N) des Stromversorgungsystems (6) nach einem der ersten Fehlerstrom-Schutzeinrichtung (4) nachgeschalteten Schütz (38) verbunden wird.

## Claims

1. An electric circuit arrangement (2) for the functional testing of a first residual current device (4) installed in a power supply system (6) and having a reset motor device (M) via an external snubber circuit of the first residual current device (4),
**characterized by**
a reset terminal (K_{R}), a test terminal (K_{T}) and a voltage terminal (K_{N}),
a reset switching contact (R) disposed between the reset terminal (K_{R}) and the test terminal (K_{T}) and controllable via a reset-contact control signal (25),
a series connection disposed between the test terminal (K_{T}) and the voltage terminal (K_{N}) and having a test switching contact (T) controllable via a test-contact control signal (26) and having a test-current limiter (16),
a voltage measuring device (20) for identifying a line voltage of the power supply system (6), the voltage measuring device (20) having a first voltage measuring input (21) connected to the test terminal (K_{T}), the voltage measuring device (20) having a second voltage measuring input (22) connected to the voltage terminal (K_{N}) and the voltage measuring device (20) having a voltage measuring output (24),
an interlocking device (27), which is connected to the voltage measuring-signal output (24), for electrically interlocking the test-contact control signal (26).

2. A test arrangement having the electric circuit arrangement (2) according to claim 1,
**characterized in that**
the reset terminal (K_{R}) is connected to the reset motor device (M) of the first residual current device (4), the test terminal (K_{T}) is connected to a first active conductor (L1) of the power supply system (6) upstream of the first residual current device (4) and the voltage terminal (K_{N}) is connected to a second active conductor (N) of the power supply system (6) downstream of the first residual current device (4).

3. A charging station (30) for an electric vehicle (8) having the electric circuit arrangement (2) according to claim 1, the charging station (30) having a charge controller (32) having a power supply (34), which is connected to the power supply system (6) using a circuit breaker (36) via a line branch (7) branching upstream of the residual current device (4),
**characterized in that**
the reset terminal (K_{R}) is connected to the reset motor device (M) of the first residual current device (4), the test terminal (K_{T}) is connected to a first active conductor (L1) in the branching line branch (7) of the power supply system (6) between the circuit breaker (36) and the power supply (34) and
the voltage terminal (K_{N}) is connected to a second active conductor (N) of the power supply system (6) downstream of the first residual current device (4).

4. A charging station (30) for an electric vehicle (8) having the electric circuit arrangement (2) according to claim 1, the charging station (30) having a charge controller (32) having a power supply (34) in order to control the electric circuit arrangement (2), the power supply (34) being connected to the power supply system (6) using a circuit breaker (36) and using a second residual current device (37) switched downstream of the circuit breaker (36) via a line branch (7) branching upstream of the first residual current device (4),
**characterized in that**
the reset terminal (K_{R}) is connected to the reset motor device (M) of the first residual current device (4), the test terminal (K_{T}) is connected to a first active conductor (L1) in the branching line branch (7) of the power supply system (6) between the second residual current device (37) and the power supply (34) and a connecting line (40) of the voltage terminal (K_{N}) is guided via the second residual current device (37) and is connected to a second active conductor (N) of the power supply system (6) downstream of the first residual current device (4).

5. The charging station according to claim 3 or 4,
**characterized in that**
the terminal line (40) of the voltage terminal (K_{N}) is connected to the second active conductor (N) of the power supply system (6) downstream of a contactor (38) switched downstream of the first residual current device (4).

6. A test method for the functional testing of a first residual current device (4), which is installed in a power supply system (6) and having a reset motor device (M), via an external snubber circuit of the first residual current device (4) by means of an electric circuit device (2) according to claim 1, the test method comprising the following steps:
testing whether a line voltage is present between a first (L1) and a second (N) active conductor of the power supply system (6) by means of the voltage measuring device (20), the first active conductor (L1) being connected to the first voltage measuring input (21) upstream of the first residual current device (4) via the test terminal (K_{T}) and the second active conductor (N) being connected to the second voltage measuring input (22) downstream of the first residual current device (4) via the voltage terminal (K_{N});
should a line voltage be identified by the voltage measuring device (20), closing the test switching contact (T) when a test-contact control signal (26) is being supplied so a defined test current flows from the first active conductor (L1) to the second active conductor (N) in a test-current circuit via the test terminal (K_{T}) and the voltage terminal (K_{N}) for a specific period of time, and triggering the first residual current device (4) when functioning properly, or, should no line voltage be identified by the voltage measuring device (20), an interlocking of the test-contact control signal (26) via the interlocking device (27), and, should the test switching contact (T) be closed,
opening the test switching contact (T),
reclosing the first residual current device (4) by means of the reset-contact control signal (25) so the reset motor device (M) of the first residual current device (4) is subjected to the line voltage via the closed reset switching contact (R) and via the reset terminal (K_{R}), and the resupplied line voltage is identified via the voltage measuring device (20) downstream of the residual current device (4), and the electric interlocking of the test switching contact (T) is suspended via the interlocking device (27);
should the voltage measuring device (20) continue to detect a line voltage after the defined test current has flowed, a malfunction of the first residual current device (4) is present.

7. The test method according to claim 6 in a charging station (30) for an electric vehicle (8), the charging station (30) having a charge controller (32) having a power supply (34), which is connected to the power supply system (6) using a circuit breaker (36) via a line branch (7) branching upstream of the first residual current device (4),
**characterized in that**
the test terminal (K_{T}) is connected to the first active conductor (L1) in the branching line branch (7) of the power supply system (6) between the circuit breaker (36) and the power supply (34).

8. The test method according to claim 6 in a charging station (30) for an electric vehicle (8), the charging station (30) having a charge controller (32) having a power supply (34) in order to control the electric circuit arrangement (2), the power supply (34) being connected to the power supply system (6) using a circuit breaker 836) via a line branch (7) branching upstream of the first residual current device (4) and using a second residual current device (37) switched downstream of the circuit breaker (36),
**characterized in that**
a terminal line (40) of the voltage terminal (K_{N}) is guided via the second residual current device (37) and is connected to the second active conductor (N) of the power supply system (6) downstream of the first residual current device (4).

9. The test method according to claim 7 or 8,
**characterized in that**
the terminal line (40) of the voltage terminal (K_{N}) is connected to the second active conductor (N) of the power supply system (6) downstream of a contactor (38) switched downstream of the first residual current device (4).

## Revendications

1. Arrangement de circuit (2) électrique pour l'essai de fonctionnement d'un premier dispositif à courant différentiel résiduel (4) installé dans un système d'alimentation électrique (6) et ayant un dispositif (M) de moteur de rappel par un circuit d'amortissement extérieur du premier dispositif à courant différentiel résiduel (4),
**caractérisé par**
une borne de rappel (K_{R}), une borne d'essai (K_{T}) et une borne de tension (K_{N}),
un contact (R) de commutation de rappel disposé entre la borne de rappel (K_{R}) et la borne d'essai (K_{T}) et contrôlable par un signal de commande (25) du contact de rappel,
un montage en série disposé entre la borne d'essai (K_{T}) et la borne de tension (K_{N}) et ayant un contact (T) de commutation d'essai contrôlable par un signal de commande (26) du contact d'essai et un limiteur (16) de courant d'essai,
un dispositif (20) de mesure de tension pour l'identification d'une tension d'alimentation du système d'alimentation électrique (6), le dispositif (20) de mesure de tension ayant une première entrée (21) de mesure de tension reliée à la borne d'essai (K_{T}), le dispositif (20) de mesure de tension ayant une deuxième entrée (22) de mesure de tension reliée à la borne de tension (K_{N}) et le dispositif (20) de mesure de tension ayant une sortie (24) de mesure de tension,
un dispositif d'asservissement (27), qui est relié au sortie (24) de signal de mesure de tension, pour l'asservissement électrique du signal de commande (26) du contact d'essai.

2. Arrangement d'essai ayant l'arrangement de circuit (2) électrique selon la revendication 1,
**caractérisé en ce que**
la borne de rappel (K_{R}) est reliée au dispositif (M) de moteur de rappel du premier dispositif à courant différentiel résiduel (4), la borne d'essai (K_{T}) est reliée à un premier conducteur actif (L1) du système d'alimentation électrique (6) en amont du premier dispositif à courant différentiel résiduel (4) et la borne de tension (K_{N}) est reliée à un deuxième conducteur actif (N) du système d'alimentation électrique (6) en aval du premier dispositif à courant différentiel résiduel (4).

3. Station de charge (30) pour un véhicule électrique (8) ayant l'arrangement de circuit (2) électrique selon la revendication 1, la station de charge (30) ayant un régulateur de charge (32) ayant une alimentation électrique (34) qui est reliée au système d'alimentation électrique (6) par une branche d'alimentation (7) branchant en amont du dispositif à courant différentiel résiduel (4) en utilisant un interrupteur (36) de circuit d'alimentation,
**caractérisé en ce que**
la borne de rappel (K_{R}) est reliée au dispositif (M) de moteur de rappel du premier dispositif à courant différentiel résiduel (4), la borne d'essai (K_{T}) est reliée au premier conducteur actif (L1) dans la branche d'alimentation (7) branchant du système d'alimentation électrique (6) entre l'disjoncteur d'alimentation (36) et l'alimentation électrique (34) et
la borne de tension (K_{N}) est reliée au deuxième conducteur actif (N) du système d'alimentation électrique (6) en aval du premier dispositif à courant différentiel résiduel (4).

4. Station de charge (30) pour un véhicule électrique (8) ayant l'arrangement de circuit (2) électrique selon la revendication 1, la station de charge (30) ayant un régulateur de charge (32) ayant une alimentation électrique (34) afin de commander l'arrangement de circuit (2) électrique, l'alimentation électrique (34) étant reliée au système d'alimentation électrique (6) en utilisant un disjoncteur d'alimentation (36) et en utilisant un deuxième dispositif à courant différentiel résiduel (37) commuté en aval de l'disjoncteur d'alimentation (36) par une branche d'alimentation (7) branchant en amont du premier dispositif à courant différentiel résiduel (4),
**caractérisé en ce que**
la borne de rappel (K_{R}) est reliée au dispositif (M) de moteur de rappel du premier dispositif à courant différentiel résiduel (4), la borne d'essai (K_{T}) est reliée à un premier conducteur actif (L1) dans la branche d'alimentation (7) branchant du système d'alimentation électrique (6) entre le deuxième dispositif à courant différentiel résiduel (37) et l'alimentation électrique (34) et une ligne (40) de la borne de tension (K_{N}) est guidée par le deuxième dispositif à courant différentiel résiduel (37) et est reliée à un deuxième conducteur actif (N) du système d'alimentation électrique (6) en aval du premier dispositif à courant différentiel résiduel (4).

5. Station de charge selon la revendication 3 ou la revendication 4,
**caractérisé en ce que**
la ligne (40) de la borne de tension (K_{N}) est reliée au deuxième conducteur actif (N) du système d'alimentation électrique (6) en aval d'un contacteur (38) commuté en aval du premier dispositif à courant différentiel résiduel (4).

6. Procédé d'essai pour l'essai de fonctionnement d'un premier dispositif à courant différentiel résiduel (4), qui est installé dans un système d'alimentation électrique (6) et ayant un dispositif (M) de moteur de rappel, par un circuit d'amortissement extérieur du premier dispositif à courant différentiel résiduel (4) au moyen d'un arrangement de circuit (2) électrique selon la revendication 1, le procédé d'essai comprenant les étapes suivantes :
essai si une tension d'alimentation soit disponible entre un premier (L1) et un deuxième (N) conducteur actif du système d'alimentation électrique (6) au moyen du dispositif (20) de mesure de tension, le premier conducteur actif (L1) étant relié à la première entrée (21) de mesure de tension en amont du premier dispositif à courant différentiel résiduel (4) par la borne d'essai (K_{T}) et le deuxième conducteur actif (N) étant relié à la deuxième entrée (22) de mesure de tension en aval du premier dispositif à courant différentiel résiduel (4) par la borne de tension (K_{N}) ;
si une tension d'alimentation soit identifiée par le dispositif (20) de mesure de tension, fermeture du contact (T) de commutation d'essai quand un signal de commande (26) du contact d'essai est injecté de sorte qu'un courant d'essai défini écoule à partir du premier conducteur actif (L1) au deuxième conducteur actif (N) dans un circuit de courant d'essai par la borne d'essai (K_{T}) et la borne de tension (K_{N}) pour une durée spécifiée, et déclenchement du premier dispositif à courant différentiel résiduel (4) quand il fonctionne régulièrement, ou, si une tension d'alimentation ne soit pas identifiée par le dispositif (20) de mesure de tension, verrouillage du signal de commande (26) du contact d'essai par le dispositif de verrouillage (27), et, si le contact (T) de commutation d'essai soit fermé, ouverture du contact (T) de commutation d'essai,
réenclenchement du premier dispositif à courant différentiel résiduel (4) au moyen du signal de commande (25) du contact de rappel de sorte que le dispositif (M) de moteur de rappel du premier dispositif à courant différentiel résiduel (4) est soumis à la tension d'alimentation par le contact (R) de commutation de rappel fermé et par la borne de rappel (K_{R}), et la tension d'alimentation récommutée est identifiée par le dispositif (20) de mesure de tension en aval du dispositif à courant différentiel résiduel (4), et le verrouillage électrique du contact (T) de commutation d'essai est terminé par le dispositif de verrouillage (27) ;
si le dispositif (20) de mesure de tension continue à détecter une tension d'alimentation après le courant d'essai défini a écoulé, un fonctionnement incorrect du premier dispositif à courant différentiel résiduel (4) existe.

7. Procédé d'essai selon la revendication 6 dans une station de charge (30) pour un véhicule électrique (8), la station de charge (30) ayant un régulateur de charge (32) ayant une alimentation électrique (34), qui est reliée au système d'alimentation électrique (6) en utilisant un disjoncteur d'alimentation (36) par une branche d'alimentation (7) branchant en amont du premier dispositif à courant différentiel résiduel (4),
**caractérisé en ce que**
la borne d'essai (K_{T}) est reliée au premier conducteur actif (L1) dans la branche d'alimentation (7) branchant du système d'alimentation électrique (6) entre l'disjoncteur d'alimentation (36) et l'alimentation électrique (34).

8. Procédé d'essai selon la revendication 6 dans une station de charge (30) pour un véhicule électrique (8), la station de charge (30) ayant un régulateur de charge (32) ayant une alimentation électrique (34) afin de commander l'arrangement de circuit (2) électrique, l'alimentation électrique (34) étant reliée au système d'alimentation électrique (6) en utilisant un disjoncteur d'alimentation (36) et en utilisant un deuxième dispositif à courant différentiel résiduel (37) commuté en aval de l'disjoncteur d'alimentation (36) par une branche d'alimentation (7) branchant en amont du premier dispositif à courant différentiel résiduel (4),
**caractérisé en ce**
**qu'**une ligne (40) de la borne de tension (K_{N}) est guidée par le deuxième dispositif à courant différentiel résiduel (37) et est relié au deuxième conducteur actif (N) du système d'alimentation électrique (6) en aval du premier dispositif à courant différentiel résiduel (4).

9. Procédé d'essai selon la revendication 7 ou la revendication 8,
**caractérisé en ce que**
la ligne (40) de la borne de tension (K_{N}) est reliée au deuxième conducteur actif (N) du système d'alimentation électrique (6) en aval d'un contacteur (38) commuté en aval du premier dispositif à courant différentiel résiduel (4).
